# EUROPÄISCHE PATENTSCHRIFT

(11) **EP 2 431 329 B1**
(45) Veröffentlichungstag und Bekanntmachung des Hinweises auf die Patenterteilung: **04.12.2013**
(21) Anmeldenummer: 11180861.4
(22) Anmeldetag: 12.09.2011
(51) Int. Cl.: C01B 33/02, C01B 33/035, B23K 13/02, B29C 65/02, C01B 33/037

(54) **Verfahren zur Herstellung von Silicium-Dünnstäben**
Method for producing thin silicon rods
Procédé de fabrication de tiges fines de silicium

(30) Priorität: 15.09.2010 DE 102010040836
(43) Veröffentlichungstag der Anmeldung: 21.03.2012
(73) Patentinhaber: Wacker Chemie AG, 81737 München (DE)
(72) Erfinder: Wochner, Dr. Hanns, 84489 Burghausen (DE); Häckl, Dr. Walter, 84367 Zeilarn (DE)
(74) Vertreter: Killinger, Andreas

(56) Entgegenhaltungen:
- DE-A1- 19 741 465
- DE-A1-102007 039 638
- US-A- 3 017 251
- US-B1- 6 573 471

## Beschreibung

Gegenstand der Erfindung ist ein Verfahren zur Herstellung von Silicium-Dünnstäben.

Silicium-Dünnstäbe werden zur Abscheidung von polykristallinem Silicium verwendet.

Polykristallines Silicium (kurz: Polysilicium) dient als Ausgangsmaterial bei der Herstellung von einkristallinem Silicium mittels Tiegelziehen (Czochralski- oder CZ-Verfahren)-oder mittels Zonenschmelzen (Floatzone oder FZ-Verfahren). Dieses einkristalline Silicium wird in Scheiben (Wafer) zertrennt und nach einer Vielzahl von mechanischen, chemischen und chemo-mechanischen Bearbeitungen in der Halbleiterindustrie zur Fertigung von elektronischen Bauelementen (Chips) verwendet.

Insbesondere wird aber polykristallines Silicium in verstärktem Maße zur Herstellung von ein- oder multikristallinem Silicium mittels Zieh- oder Gieß-Verfahren benötigt, wobei dieses ein-oder multikristalline Silicium zur Fertigung von Solarzellen für die Photovoltaik dient.

Das polykristalline Silicium, oft auch kurz Polysilicium genannt, wird üblicherweise mittels des Siemens-Prozesses hergestellt. Dabei werden in einem glockenförmigen Reaktor ("Siemens-Reaktor") Dünnstäbe aus Silicium durch direkten Stromdurchgang erhitzt und ein Reaktionsgas enthaltend eine Silicium enthaltende Komponente und Wasserstoff eingeleitet.

Die Silicium-Dünnstäbe weisen üblicherweise eine Kantenlänge von 3 bis 15 mm auf.

Als Silicium enthaltende Komponenten kommen beispielsweise Siliciumhalogenverbindungen wie Siliciumchlorverbindungen, insbesondere Chlorsilane in betracht. Die Silicium enthaltende Komponente wird zusammen mit Wasserstoff in den Reaktor eingeleitet. Bei Temperaturen von mehr als 1000 °C wird auf den Dünnstäben Silicium abgeschieden. Dabei ergibt sich schließlich ein Stab mit polykristallinem Silicium. In DE 1 105 396 sind die Grundprinzipien des Siemens-Prozesses beschrieben. Bezüglich der Herstellung von Dünnstäben ist aus DE 1 177 119 bekannt, Silicium auf einem Trägerkörper aus Silicium (= Dünnstab) abzuscheiden, anschließend davon einen Teil abzutrennen und diesen abgetrennten Teil wiederum als Trägerkörper für die Abscheidung von Silicium zu verwenden. Das Abtrennen kann mechanisch, z.B. mittels Zersägen, oder elektrolytisch mittels eines Flüssigkeitsstrahls erfolgen. Beim mechanischen Abtrennen von Dünnstäben wird deren Oberfläche jedoch mit Metallen sowie mit Bor-, Phosphor-, Aluminium- und Arsenverbindungen kontaminiert. Die Oberflächenkontamination mit Metallen beträgt nach mechanischer Abtrennung etwa bis zu 90000-160000 pptw (parts per trillion by weight). Die mittlere Belastung mit B, P, Al und As liegt im Bereich von 60 bis 700 ppta (parts per trillion atomic).

Daher ist es üblicherweise nötig, die Dünnstäbe einer Oberflächenreinigung zu unterziehen, bevor sie zur Abscheidung von Silicium verwendet werden können. DE 1 177 119 offenbart diesbezüglich eine Reinigung auf mechanischem Weg, z.B. durch Sandstrahlen, oder auf chemischem Weg durch Ätzen.

Durch Behandlung der Dünnstäbe in einem Ätzbecken aus kontaminationsarmem Material, z.B. Kunststoff, mittels einer Mischung aus HF und HN03, lassen sich die Oberflächenkontaminationen deutlich reduzieren, bei Metallen auf bis zu 300 pptw und weniger, bei B, P, Al und As auf weniger als 15 pptw.

In EP 0 548 504 A2 wird ein Reinigungsverfahren beschrieben, bei dem HF und HNO3 zur Reinigung von Silicium verwendet werden.

Ein anderes Reinigungsverfahren ist aus DE 195 29 518 A1, bekannt. Dabei wird polykristallines Silicium zuerst mit einer Mischung aus Königswasser (Mischung aus HCl und HNO3) gereinigt und dann einer zusätzlichen Reinigung mit HF unterzogen wird.

EP 0 905 796 A1 offenbart ein Verfahren zur Herstellung von Halbleitermaterial, das eine niedrige Metallkonzentration aufweist, dadurch gekennzeichnet, dass polykristallines Silicium in einer Vorreinigung in zumindest einer Stufe mit einer oxidierenden Reinigungslösung gewaschen wird, in einer Hauptreinigung in einer weiteren Stufe mit einer Reinigungslösung gewaschen wird, die HNO3 und HF enthält, und bei einer Hydrophilierung in noch einer weiteren Stufe mit einer oxidierenden Reinigungsflüssigkeit gewaschen wird. Durch dieses Reinigungsverfahren lässt sich der Eisen- und/oder Chromgehalt auf der Oberfläche des Siliciums von 1,332 x 10⁻⁸ g/cm² (nach Bearbeitung mit Metallwerkzeug) auf weniger als 6,66 x 10⁻¹¹ g/cm² reduzieren.

Um die Ausbeute bei der Silicium-Abscheidung zu erhöhen, wäre es auch wünschenswert, längere Dünnstäbe einsetzen zu können. Längere Dünnstäbe sind prinzipiell mittels Verschweißen von kürzeren Dünnstäben herstellbar.

WO 02/070184 A1 beschreibt ein Verfahren, bei dem zwei Silicium-Werkstücke rissfrei mittels Schweißen miteinander verbunden werden. Zunächst werden die Werkstücke auf eine Temperatur von mindestens 600 °C aufgeheizt, vorzugsweise auf einer Heizplatte aus Silicium. Dann werden die Werkstücke z.B. mittels elektrischem, Plasma- oder Laserschweißen miteinander verbunden.

Für dünne Werkstücke ist dieses Verfahren allerdings schwer handhabbar. Zudem stehen die Silicium-Werkstücke während des Verschweißens ständig in direktem Kontakt mit Luft, was hinsichtlich Kontaminationen nachteilig ist.

US 6,573,471 B1 beschreibt ebenfalls ein Verfahren, durch das zwei Silicium-Werkstücke durch Schweißen miteinander verbunden werden können. Der wesentliche Unterschied zum Verfahren nach WO 02/070184 A1 besteht darin, dass ein Unterdruck von höchstens 0,05 Torr erzeugt wird, bevor die beiden Werkstücke verbunden werden.

US 6,852,952 B1 beschreibt ein Verfahren, bei dem zwei Silicium-Werkstücke mittels Lichtbogenschweißen miteinander verbunden werden. Dazu wird zwischen zwei Elektroden ein Plasma erzeugt, in dessen Nähe die zu verbindenden Silicium-Werkstücke gebracht werden. Dies findet vorzugsweise in Argonatmosphäre statt.

Auch das Verfahren nach US 6,852,952 B1 ist jedoch aufwändig und für das Verschweißen von Dünnstäben nachteilig.

Ein weiteres denkbares Verfahren stellt das Induktionsschweißen dar. Damit werden üblicherweise Kunststoff- und Metallteile unter Luftatmosphäre verschweißt.

Die Anwendung des Induktionsschweißens, um Silicium-Werkstücke zu verbinden, würde zur Bildung einer SiN-Schicht führen, da Silicium infolge der hohen Temperaturen von mehr als 1500 °C mit dem Stickstoff aus der Umgebungsluft reagiert. Da sich SiN in einer Siliciumschmelze nicht löst und als Partikel zu Versetzungen im Einkristall führt, ist die Verwendung solchen polykristallinen Siliciums zur Erzeugung von Siliciumeinkristallen mittels Tiegelziehen oder Zonenschmelzen nicht geeignet.

Bei langen Dünnstäben stellen die derzeit verfügbaren Ätzbecken ein weiteres Problem dar.

Die Größe der Ätzbecken für Reinigungsanlagen aus reinem Kunststoff ist nämlich konstruktionsbedingt begrenzt. Ab einer gewissen Dimension des Ätzbeckens wird die Anlage instabil. Zusätzliche Strahlverstrebungen könnten eine Vergrößerung der

Ätzbecken ermöglichen. Allerdings ist die Verwendung von Stahl kritisch, da nicht ausgeschlossen werden kann, dass infolge von Spannungsrissen Säure aus dem Ätzbecken in die Nähe der Stahlverstrebungen gelangt und die Säure mit Metallen kontaminiert wird.

Daher bestand die Aufgabe der Erfindung darin, die oben beschriebenen Nachteile zu vermeiden und den Stand der Technik zu verbessern.

Die Aufgabe wird gelöst durch ein Verfahren zu Herstellung von Silicium-Dünnstäben (1), umfassend die Schritte
a) Bereitstellen eines Stabes aus polykristallinem Silicium, von dem wenigstens zwei Dünnstäbe (11, 12) mit gegenüber dem Stab aus polykristallinem Silicium reduziertem Querschnitt abgetrennt werden;
b) Reinigung der wenigstens zwei abgetrennten Dünnstäbe (11, 12) durch Behandlung mit einem Material abtragenden flüssigen Medium;
c) Verschweißen von wenigstens zwei der gereinigten Dünnstäbe (11, 12) zu einem längeren Dünnstab (1);
d) Verpacken des längeren Dünnstabs (1) in eine Schlauchfolie (100). Bevorzugte Ausführungsformen sind in den abhängigen Ansprüchen beansprucht.

Ausgangspunkt des Verfahrens ist ein Stab aus polykristallinem Silicium, hergestellt durch Abscheiden von Silicium auf einem Dünnstab, vorzugsweise mittels des Siemens-Prozesses.

Dieser Stab aus polykristallinem Material wird in Dünnstäbe zertrennt. Vorzugsweise erfolgt das Abtrennen der Dünnstäbe mechanisch mittels Sägen.

Die abgetrennten Dünnstäbe werden anschließend chemisch gereinigt.

Vorzugsweise findet vor dem Verschweißen der Dünnstäbe genau ein Reinigungsschritt statt.

Dieser Reinigungsschritt erfolgt vorzugsweise in einem Reinraum einer Reinraumklasse 100 oder niedriger (nach US FED STD 209E, abgelöst durch ISO 14644-1).

Bei Klasse 100 (ISO 5) dürfen max. 3,5 Partikel von max. 0,5 µm Durchmesser pro Liter enthalten sein.

Vorzugsweise erfolgt die chemische Reinigung mittels eines HF/HNO₃-Gemisches.

Dann werden die Dünnstäbe verschweißt.

Das Verschweißen der gereinigten Dünnstäbe erfolgt vorzugsweise unter Inertgas.

Vorzugsweise erfolgt das Verschweißen mittels eines Induktionsverfahrens.

Die Erfindung wird im Folgenden auch anhand von Figuren erläutert.

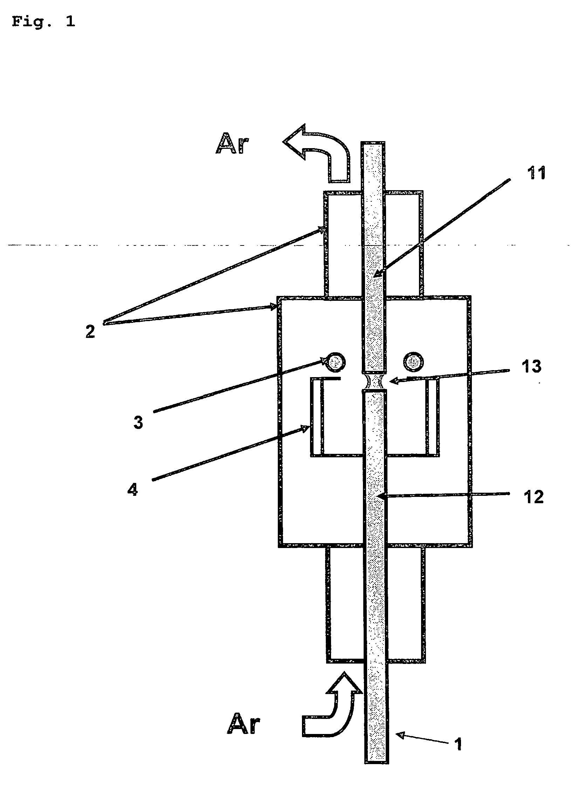

**Fig. 1** zeigt schematisch, wie zwei Dünnstäbe verschweißt werden.

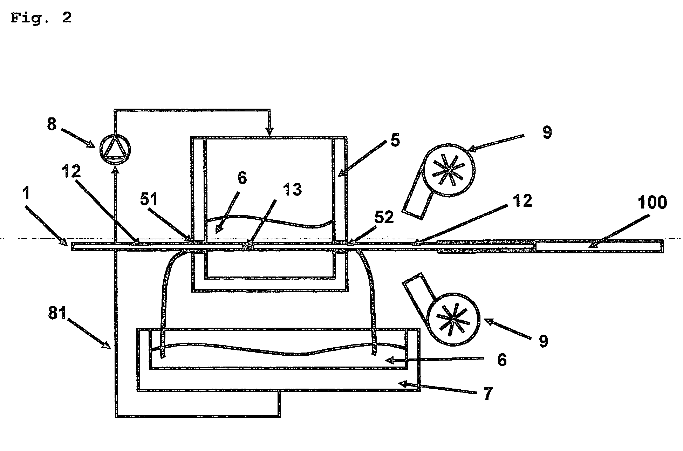

**Fig. 2** zeigt schematisch, wie ein verschweißter Dünnstab in einem Ätzbecken behandelt wird.

### Liste der verwendeten Bezugszeichen

- **1**: verschweißter Dünnstab
- **11**: erster Dünnstab
- **12**: zweiter Dünnstab
- **13**: Schweißnaht
- **2**: Quarzrohr
- **3**: Induktionsspule
- **4**: Kohlenstoffrohr
- **5**: Ätzbehälter/Becken
- **51**: Öffnung
- **52**: Öffnung
- **6**: Ätzflüssigkeit
- **7**: Wanne
- **8**: Pumpe
- **81**: Leitung
- **9**: Trocknungseinheit
- **100**: Folienschlauch

Das Schweißen der kurzen Dünnstäbe **11** und **12** aus Silicium erfolgt in einer Vorrichtung, in der die zwei Dünnstäbe **11** und **12** unter Schutzgas (besonders bevorzugt Argon) zunächst in Kontakt gebracht werden.

Eine Induktionsspule **3** erhitzt die beiden Enden der Stäbe **11** und **12** über die Schmelztemperatur von Silicium (> 1412°C) und es entsteht ein Tropfen aus flüssigem Silicium, der durch Oberflächenspannung in Form gehalten wird. Nach maximal 4 bis 5 Minuten ist das Silicium an den Enden der beiden Stäbe flüssig und die Induktionsspule **3** wird ausgeschaltet. Die beiden Stäbe **11** und **12** wachsen zusammen.

Eine Induktionsspule **3** sitzt über einem mit Quarz gekapselten Rohr **4** aus Kohlenstoff (Graphit).

Das in der Induktionsspule **3** erzeugte Wechselfeld koppelt zunächst in das aus Kohlenstoff bestehende Rohr **4** ein und erhitzt dieses. Die Wärmestrahlung erhitzt anschließend die Stäbe aus Silizium. Ab einer bestimmten Temperatur kann das Wechselfeld auch direkt in das Silicium einkoppeln und erwärmt dies weiter. Der eigentliche Schweißvorgang kann nun gestartet werden.

Im Kohlenstoffrohr **4** entstehen Temperaturen von weit über 1000°C. Daher muss darauf geachtet werden, dass dieses Rohr von der Außenluft abgeschirmt wird. Es wird zweckmäßiger Weise in Quarz gekapselt. Um das heiße Silicium zusätzlich von der Umgebungsluft abzuschirmen, wird die gesamte Vorrichtung von einem Quarzrohr **2** umgeben. Quarz besitzt zum einen die Eigenschaft, dass es hohen Temperaturen stand hält. Andererseits ist es durchsichtig, so dass es ermöglicht wird, den Schweißvorgang zu beobachten.

Die hohen Temperaturen innerhalb des Quarzrohres **2** führen zu einer vergleichsweise starken konvektiven Strömung von unten nach oben.

Werden hier keine gesonderten Maßnahmen getroffen, wird Umgebungsluft angesaugt und zur Schweißstelle geführt.

Dies wäre aber mit zwei Nachteilen verbunden:
- Zusätzliche Verunreinigungen der Schweißstelle und
- chemische Reaktionen mit der Luft (Stickstoff und Sauerstoff).

Besonders die Reaktion mit Stickstoff ist unter allen Umständen zu vermeiden, da bei der Reaktion SiN gebildet wird, das beim späteren Kristallziehprozess Probleme bereiten würde. Daher wird das Quarzrohr von unten her mit einem Schutzgas (Edelgas, Argon) versorgt.

Als Schutzgas ist Argon besonders bevorzugt. Prinzipiell können aber auch andere inerte Gase verwendet werden.

An der oberen Öffnung kann das Schutzgas wieder entweichen. Die konvektive Strömung, die durch die hohe Temperatur des Siliciums verursacht wird, sorgt dafür, dass die Umgebungsluft praktisch nicht mit dem heißen Silicium in Kontakt gerät.

Anschließend werden die verschweißten Dünnstäbe in Schlauchbeutel **100** verpackt.

Das Verpacken der verschweißten Dünnstäbe erfolgt vorzugweise in eine Schlauchfolie aus höchstreinem PE. Die verwendeten Beutel bestehen idealer weise aus hochreinem PE mit einer Dicke von 40 bis 100 µm.

Während des Schweißvorganges wird die Si-Oberfläche auf der gesamten Dünnstablänge mit Verunreinigungen leicht kontaminiert.

Es zeigte sich, dass Dünnstäbe, die mit diesem Verfahren erhalten werden, sowohl für die Herstellung von Polysilicium für die Halbleiterindustrie (CZ) als auch für die Solarindustrie eingesetzt werden können.

Polykristallines Silicium, das durch Abscheidung auf derart erzeugten Dünnstäben abgeschieden wird, kann auch im Zonenschmelzverfahren (FZ) zu Einkristallen weiter verarbeitet werden.

Die Ziehausbeute für einen Widerstand von kleiner 1000 ohm·cm liegt dabei aber wegen der doch noch vorhandenen Verunreinigungen nur bei weniger als 50 %, was nachteilig ist.

Da Hochohmiges Material aber zunehmend benötigt wird, ist es bevorzugt, die Ausbeute zu erhöhen. Um dies zu bewerkstelligen, ist es notwendig, die Konzentration an Metallen auf der Si-Oberfläche und im Bulk des eingesetzten Dünnstabes von ca. 10¹² at/cm² auf etwa 10¹¹ at/cm² zu reduzieren.

Von Verunreinigungen wie Eisen, Kupfer und Nickel ist bekannt, dass sie auch die Lebensdauer der Minoritätsladungsträger im Silicium drastisch reduzieren. Dies hat sowohl negative Konsequenzen für die Verwendung eines solchen Materials bei Halbleiteranwendungen (dort müssen dann zusätzliche Getter für Metalle verwendet werden) als auch bei Solaranwendungen (die Lebensdauer bestimmt dann zu einem großen Teil den Wirkungsgrad der Solarzelle).

Daher findet vorzugsweise unmittelbar vor dem Verpacken ein zusätzlicher Reinigungsschritt statt.

Auch dieser zusätzliche Reinigungsschritt erfolgt vorzugsweise in einem Reinraum einer Reinraumklasse 100 oder niedriger.

Vorzugsweise erfolgt auch die zweite chemische Reinigung mittels eines HF/HNO₃-Gemisches.

Werden die geschweißten Dünnstäbe nach dem Verschweißen noch einmal gereinigt, dann können die Verunreinigungen, die sich auf der Siliciumoberfläche des Dünnstabes beim Schweißen abgelagert haben, entfernt werden.

**Tabelle 1** zeigt die Oberflächenkontamination mit Metallen in pptw nach dem Verschweißen ohne einen zweiten Reinigungsschritt.

**Tabelle 1**

| | Fe | Cr | Ni | Na | Zn | Al | Cu | Mo | Ti | W | K | Co | Mn | Ca | Mg | V | Ag |
|---|---|---|---|---|---|---|---|---|---|---|---|---|---|---|---|---|---|
| | | | | | | | | | | | | | | | | | |
| 25% Quantil | 2017 | 43 | 138 | 2908 | 938 | 976 | 77 | 2 | 124 | 14 | 1707 | 7 | 34 | 3849 | 728 | 2 | 11 |
| Median | 2622 | 98 | 170 | 4428 | 2166 | 1260 | 110 | 5 | 218 | 21 | 2395 | 9 | 52 | 4379 | 958 | 3 | 15 |
| Mittelwert | 2711 | 123 | 160 | 4551 | 2645 | 1221 | 114 | 15 | 339 | 43 | 2331 | 10 | 56 | 4553 | 978 | 7 | 16 |
| 75% Quantil | 3624 | 163 | 185 | 5169 | 4870 | 1667 | 159 | 7 | 305 | 40 | 2698 | 14 | 77 | 6655 | 1389 | 5 | 22 |

**Tabelle 2** zeigt die Dotierstoffkonzentrationen in ppta nach dem Verschweißen ohne einen zweiten Reinigungsschritt.

**Tabelle 2**

| | B | P | Al | As |
|---|---|---|---|---|
| | | | | |
| Median | 109 | 104 | 5 | 11 |
| Mittelwert | 132 | 131 | 17 | 18 |

Das zweite chemische Reinigen kann mit deutlich unterschiedlichen Ätzabträgen erfolgen, wie in den nachfolgenden Beispielen gezeigt wird.

### Beispiel 1

In **Beispiel 1** ist der Ätzabtrag mit weniger als 1 µm beim zweiten Reinigungsschritt vergleichsweise niedrig.

Dagegen ist der Abtrag beim ersten Reinigungsschritt 30 µm.

Der erste Reinigungsschritt umfasst eine Vorreinigung, eine Hauptreinigung, einen Spülschritt und eine Hydrophilierung.

Bei der Vorreinigung wird der Dünnstab für 5 Minuten in einer Mischung aus 11 Gew.-% HCl, 5 Gew.-% HF und 1,5 Gew.-% H₂O₂ bei einer Temperatur von 20°C gereinigt.

Die Hauptreinigung erfolgt für 5 Minuten bei 8 °C in einer HF/HNO3-Mischung mit 6 Gew.-% HF, 55 Gew.-% HNO₃ und 1 Gew.-% Si.

Der Ätzabtrag beträgt ca. 30 µm.

Anschließend wird der geätzte Dünnstab für 5 Minuten mit 22 °C warmen Reinstwasser mit 18 MOHM gespült.

Schließlich erfolgt eine 5 minütige Hydrophilierung in 22 °C warmen Wasser, das mit 20 ppm Ozon gesättigt ist.

Schließlich wird der Dünnstab für 60 Minuten mit Reinstluft der Reinraumklasse 100 bei 80 °C getrocknet.

Nach dem Verschweißen der gereinigten Dünnstäbe erfolgt ein zweites Chemisches Reinigen zum Entfernen der durch das Schweißen auf die Siliciumoberfläche gelangten Partikel.

Der Materialabtrag beträgt dabei weniger als 1 µm.

Bei der Vorreinigung wird der Dünnstab für 5 Minuten in einer Mischung aus 11 Gew.-% HCl, 5 Gew.-% HF und 1,5 Gew.-% H₂O₂ bei einer Temperatur von 20°C gereinigt.

Die Hauptreinigung erfolgt für 0,1 Minuten bei 8 °C in einer HF/HN03-Mischung mit 6 Gew.-% HF, 55 Gew.-% HNO₃ und 1 Gew.-% Si.

Der Ätzabtrag beträgt ca. 30 µm.

Anschließend wird der geätzte Dünnstab für 5 Minuten mit 22 °C warmen Reinstwasser mit 18 MOHM gespült.

Schließlich erfolgt eine 5 minütige Hydrophilierung in 22 °c warmen Wasser, das mit 20 ppm Ozon gesättigt ist.

Schließlich wird der Dünnstab für 60 Minuten mit Reinstluft der Reinraumklasse 100 bei 80 °C getrocknet.

Bezüglich der Kontaminationen mit Metallen und Dotierstoffen wurden 21 Dünnstäbe aus **Beispiel 1** untersucht.

**Tabelle 3** zeigt die Oberflächenkontamination mit Metallen in pptw für **Beispiel 1.**

**Tabelle 3**

| | Fe | Cr | Ni | Na | Zn | Al | Cu | Mo | Ti | W | K | Co | Mn | Ca | Mg | V | Ag |
|---|---|---|---|---|---|---|---|---|---|---|---|---|---|---|---|---|---|
| | | | | | | | | | | | | | | | | | |
| 25% Quantil | 9 | 0 | 0 | 4 | 0 | 2 | 0 | 0 | 3 | 0 | 7 | 0 | 0 | 11 | 2 | 0 | 1 |
| Median | 13 | 1 | 0 | 6 | 1 | 4 | 0 | 0 | 4 | 1 | 8 | 0 | 0 | 49 | 6 | 0 | 2 |
| Mittelwert | 18 | 1 | 0 | 17 | 2 | 6 | 0 | 0 | 4 | 1 | 10 | 0 | 0 | 101 | 12 | 0 | 3 |
| 75% Quantil | 23 | 1 | 0 | 16 | 2 | 7 | 1 | 0 | 5 | 2 | 11 | 0 | 0 | 128 | 13 | 0 | 4 |

**Tabelle 4** zeigt die Dotierstoffkonzentrationen in ppta für **Beispiel 1.**

**Tabelle 4**

| | B | P | Al | As |
|---|---|---|---|---|
| | | | | |
| Median | 30 | 25 | 3 | 6 |
| Mittelwert | 35 | 32 | 12 | 11 |

Es zeigen sich deutliche Reduktionen sowohl der Metallkontaminationen (vgl. Tabelle 1) als auch der Verunreinigungen mit B, P, Al und As (vgl. Tabelle 2) durch den zweiten Reinigungsschritt.

### Beispiel 2

In **Beispiel 2** ist der Ätzabtrag mit etwa 30 µm beim zweiten Reinigungsschritt deutlich höher als in **Beispiel 1.** Der Einfluss höherer Ätzabträge auf die Ergebnisse soll dabei näher untersucht werden.

Der Abtrag beim ersten Reinigungsschritt beträgt ebenfalls 30 µm wie in **Beispiel 1.**

Der erste Reinigungsschritt umfasst wiederum eine Vorreinigung, eine Hauptreinigung, einen Spülschritt und eine Hydrophilierung.

Bei der Vorreinigung wird der Dünnstab für 5 Minuten in einer Mischung aus 11 Gew.-% HCl, 5 Gew.-% HF und 1,5 Gew.-% H₂O₂ bei einer Temperatur von 20°C gereinigt.

Die Hauptreinigung erfolgt für 5 Minuten bei 8 °C in einer HF/HN03-Mischung mit 6 Gew.-% HF, 55 Gew.-% HNO₃ und 1 Gew.-% Si.

Der Ätzabtrag beträgt ca. 30 µm.

Anschließend wird der geätzte Dünnstab für 5 Minuten mit 22 °C warmen Reinstwasser mit 18 MOHM gespült.

Schließlich erfolgt eine 5 minütige Hydrophilierung in 22 °C warmen Wasser, das mit 20 ppm Ozon gesättigt ist.

Schließlich wird der Dünnstab für 60 Minuten mit Reinstluft der Reinraumklasse 100 bei 80 °C getrocknet.

Nach dem Verschweißen der gereinigten Dünnstäbe erfolgt ein zweites chemisches Reinigen zum Entfernen der durch das Schweißen auf die Siliciumoberfläche gelangten Partikel.

Der Materialabtrag beträgt dabei etwa 30 µm.

Bei der Vorreinigung wird der Dünnstab für 5 Minuten in einer Mischung aus 11 Gew.-% HCl, 5 Gew.-% HF und 1,5 Gew.-% H₂O₂ bei einer Temperatur von 20°C gereinigt.

Die Hauptreinigung erfolgt für 5 Minuten bei 8 °C in einer HF/HNO3-Mischung mit 6 Gew.-% HF, 55 Gew.-% HNO₃ und 1 Gew.-% Si

Der Ätzabtrag beträgt ca. 30 µm.

Anschließend wird der geätzte Dünnstab für 5 Minuten mit 22 °C warmen Reinstwasser mit 18 MOHM gespült.

Schließlich erfolgt eine 5 minütige Hydrophilierung in 22 °c warmen Wasser, das mit 20 ppm Ozon gesättigt ist.

Schließlich wird der Dünnstab für 60 Minuten mit Reinstluft der Reinraumklasse 100 bei 80 °C getrocknet.

Bezüglich der Kontaminationen mit Metallen und Dotierstoffen wurden 21 Dünnstäbe aus **Beispiel 2** untersucht.

**Tabelle 5** zeigt die Oberflächenkontamination mit Metallen in pptw für **Beispiel 2.**

**Tabelle 5**

| | Fe | Cr | Ni | Na | Zn | Al | Cu | Mo | Ti | W | K | Co | Mn | Ca | Mg | V | Ag |
|---|---|---|---|---|---|---|---|---|---|---|---|---|---|---|---|---|---|
| | | | | | | | | | | | | | | | | | |
| 25% Quantil | 4 | 0 | 0 | 2 | 0 | 2 | 0 | 0 | 1 | 0 | 2 | 0 | 0 | 8 | 1 | 0 | 1 |
| Median | 8 | 1 | 0 | 4 | 1 | 4 | 0 | 0 | 2 | 1 | 5 | 0 | 0 | 25 | 4 | 0 | 2 |
| Mittelwert | 14 | 1 | 0 | 8 | 2 | 6 | 0 | 0 | 4 | 1 | 7 | 0 | 0 | 55 | 8 | 0 | 3 |
| 75% Quantil | 24 | 1 | 0 | 10 | 2 | 7 | 1 | 0 | 5 | 2 | 8 | 0 | 0 | 65 | 9 | 0 | 4 |

**Tabelle 6** zeigt die Dotierstoffkonzentrationen in ppta für **Beispiel 2.**

**Tabelle 6**

| | B | P | Al | As |
|---|---|---|---|---|
| | | | | |
| Median | 6 | 9 | 1 | 1 |
| Mittelwert | 11 | 12 | 3 | 3 |

Gegenüber **Beispiel 1** zeigt sich eine Verbesserung der Kontamination bei Eisen, Calcium, Magnesium, Kalium, Natrium Aluminium, Titan und den Dotierstoffen Bor, Phosphor, Aluminium und Arsen.

Die Ergebnisse von **Beispiel 2** zeigen, dass höhere Ätzabträge bzgl. der Metallkontaminationen zu einer weiteren leichten Verbesserung bei Eisen und den Umweltelementen Calcium, Magnesium, Kalium, Natrium Aluminium, Titan führen. Die Konzentrationen an B, P, Al und As gehen ebenfalls zurück. Allerdings sind im Rahmen der Erfindung beim bevorzugten zweiten Reinigungsschritt kleine Ätzabträge von weniger als 10 µm bevorzugt. Besonders bevorzugt sind Ätzabträge von weniger als 5 µm, ganz besonders bevorzugt Ätzabträge von weniger als 2 µm.

Bei der ersten Reinigung der Dünnstäbe sind Ätzabträge von 10 µm oder mehr bevorzugt. Besonders bevorzugt sind Ätzabträge von wenigstens 20 µm und ganz besonders bevorzugt Ätzabträge von wenigstens 30 µm.

Nach bisherigen Erfahrungen können Ätzbecken für Reinigungsanlagen aus reinem Kunststoff maximal eine Außenlänge von 4 m und eine Innenlänge von 3,2 m erreichen. Die Reinigung von Dünnstäben mit einer Länge größer als 3.2 m ist mit Hilfe dieser Ätzbecken daher nicht möglich. Nach dem Verschweißen von zwei Dünnstäben kann jedoch die Länge des Dünnstabs mehr als 3,2 m erreichen, was für die Anwendung des bevorzugten zweiten Reinigungsschritts eine andere Lösung erfordert.

Die Erfinder haben erkannt, dass auch kleinere Ätzbecken zur Reinigung langer Dünnstäbe geeignet sind.

Der vorher beschriebene kurze zweite Ätzschritt der sehr langen Dünnstäbe **1** kann besonders bevorzugt in einem Becken **5** durchgeführt werden, dessen Länge kleiner als der Stab **1** ist. Dieses Becken **5** besitzt an den Stirnflächen jeweils eine Öffnung **51** bzw. **52** durch die der lange Dünnstab **1** hindurchgeführt werden kann. Ätzflüssigkeit **6**, die an diesen Öffnungen **51** und **52** an den Dünnstäben **1** vorbei ausläuft, wird in einer darunter liegenden Wanne **7** aufgefangen und mittels einer Pumpe **8** über eine Leitung **81** wieder in das Ätzbecken **5** gepumpt, so dass ein Gleichgewicht zwischen Auslaufen und Rückführung der Ätzflüssigkeit **6** besteht. Nach Durchführung des Stabes **1** durch das Ätzbecken **5** und Trocknung des Stabes **1**, kann er beinahe unverzüglich in einen Folienschlauch **100** zur Verpackung eingeführt werden. Eine weitere zusätzliche Verunreinigung wird dabei vermieden. Die Trocknung kann dabei mit Hilfe von heißer, von Partikeln gereinigter Luft erfolgen, die auf den Stab **1** geblasen wird. **9** zeigt schematisch entsprechende Trocknungseinheiten.

Die Vortriebsgeschwindigkeit des Stabes **1** und die Länge des Ätzbeckens **5** bestimmen die Verweildauer im Ätzbecken **5** und damit den Ätzabtrag. Der Vorteil dieser Methode im Vergleich zum Ätzen im herkömmlichen Ätzbecken **5** ist zum einen der geringe Platzbedarf der Anlage und zum anderen der flexiblere Aufbau. Denn mit dem gezeigten Prinzip lässt sich auch eine Kaskade mit unterschiedlichen Ätz- und Spülschritten realisieren, die in sehr kompakter Bauweise ausgeführt werden können. Auch Schritte zur Hydrophilierung können ohne Probleme in den Arbeitsablauf eingesetzt werden.

Greifer, wie sie in Ätzbecken **5** herkömmlicher Bauart verwendet werden, um die Stäbe **1** von einem Becken ins andere zu transportieren, werden in diesem Verfahren nicht benötigt. Mit dieser sehr modularen Bauweise können auch einfache Trocknungseinheiten **9** eingefügt werden, die den Dünnstab **1** einfach mit heißer Luft trocknen. Auch HF/Ozon Trockner sind denkbar und besonders vorteilhaft, bei denen die Dünnstäbe **1** in einem letzten Ätzbad durch eine verdünnte HF / Wasser Lösung gezogen werden. Beim Austritt aus der Behälteröffnung **51** bzw. **52** befindet sich noch eine HF/Wasser Schicht auf dem Dünnstab **1,** die mit einem Strom von Ozon entgegen der Transportrichtung des Stabes **1** angeblasen wird. Ozon löst sich im Flüssigkeitsfilm auf dem Dünnstab **1** und verändert die Oberflächenspannung des Films, so dass eine Trocknung nach dem Marangonieffektes einsetzt.

Die Verwendung von längeren Dünnstäben, die besonderen Anforderungen an das Niveau von Verunreinigungen genügen, verspricht den Vorteil, dass die Ausbeute pro Fahrt in einem Abscheidereaktor gesteigert werden kann.

Die Erfindung ermöglicht es somit, längere Dünnstäbe (> 3,2 m) herzustellen, die zusätzlich den hohen Anforderungen an die

Reinheit genügen. (Verunreinigung kleiner als 10¹² at/cm² oder at/cm3)

Dünnstäbe mit einer Länge von mehr als 3,2 m können durch die Verbindung zweier oder mehrerer kürzerer Dünnstäbe zu einem langen Dünnstab hergestellt werden.

Es hat sich gezeigt, dass selbst die Verwendung von geschweißten Dünnstäben mit einer Länge von kleiner als 3,2 m Vorteile während des Abscheideprozesses bietet. Offenbar verändern die Schweißstellen das Spannungsverhalten der fertigen Stäbe, so dass die Umfallrate beim Abkühlen im Siemensreaktor auf Raumtemperatur beim Ausschalten des Reaktors deutlich sinkt. Dies ist ein zusätzlicher, unerwarteter Effekt des erfindungsgemäßen Verfahrens.

Durch ein Verschweißen von gesägten, allerdings zuvor nicht gereinigten Dünnstäben wird an der Schweißstelle die Metallkonzentration an der Oberfläche auf mehr als 10¹⁶ at/cm2 erhöht.

Durch die hohe Temperatur beim Verschweißen von über 500 °C diffundieren dabei metallische und sonstige partikuläre Verunreinigungen in den Bulk des Silicium-Dünnstabes.

Solche Verunreinigungen im Bulk können durch eine Oberflächenreinigung nicht mehr entfernt werden.

Durch das erfindungsgemäße Verfahren und die zwingend erforderliche Reinigung der Dünnstäbe vor dem Verschweißen wird dies vermieden.

## Patentansprüche

1. Verfahren zu Herstellung von Silicium-Dünnstäben (1), umfassend die Schritte
a) Bereitstellen eines Stabes aus polykristallinem Silicium, von dem wenigstens zwei Dünnstäbe (11, 12) mit gegenüber dem Stab aus polykristallinem Silicium reduziertem Querschnitt abgetrennt werden;
b) Reinigung der wenigstens zwei abgetrennten Dünnstäbe (11, 12) durch Behandlung mit einem Material abtragenden flüssigen Medium;
c) Verschweißen von wenigstens zwei der gereinigten Dünnstäbe (11, 12) zu einem längeren Dünnstab (1);
d) Verpacken des längeren Dünnstabs (1) in eine Schlauchfolie (100).

2. Verfahren nach Anspruch 1, wobei nach dem Verschweißen von wenigstens zwei der Dünnstäbe (11, 12) zu einem längeren Dünnstab (1) und vor dessen Verpacken eine zweite Reinigung erfolgt, bei dem der längere Dünnstab (1) mit einem Material abtragenden flüssigen Medium behandelt wird.

3. Verfahren nach Anspruch 1 oder 2, wobei das flüssige Medium zur Behandlung der Dünnstäbe (11, 12) gemäß Schritt b) sowie bei der zweiten Reinigung des längeren Dünnstabs (1) HF und HNO₃ beinhaltet.

4. Verfahren nach Anspruch 2 oder 3, wobei eine Hydrophilierung der Dünnstäbe (11, 12) nach Reinigung gemäß Schritt b) sowie des längeren Dünnstabs (1) nach der zweiten Reinigung mittels Ozon erfolgt.

5. Verfahren nach einem der Ansprüche 2 bis 4, wobei bei der Behandlung des längeren Dünnstabs (1) mit einem Material abtragenden flüssigen Medium der Materialabtrag weniger als 10 µm beträgt.

6. Verfahren nach einem der Ansprüche 1 bis 5, wobei bei der Reinigung der Dünnstäbe (11, 12) durch Behandlung mit einem Material abtragenden flüssigen Medium gemäß Schritt b) der Materialabtrag jeweils mindestens 10 µm beträgt.

7. Verfahren nach einem der Ansprüche 2 bis 6, wobei die zweite Reinigung des längeren Dünnstabs (1) in einem Becken (5) enthaltend Material abtragendes flüssiges Medium erfolgt, dass an beiden Stirnflächen jeweils eine Öffnung (51) bzw. (52) aufweist, durch die der längere Dünnstab (1) nach und nach hindurchgeführt wird, um ihn zu reinigen, wobei Material abtragendes flüssiges Medium, das über die Öffnungen (51) und (52) am längeren Dünnstab (1) vorbei ausläuft, in einer unter dem Becken (5) angeordneten Wanne (7) aufgefangen und wieder in das Becken (5) gepumpt wird.

8. Verfahren nach Anspruch 7, wobei nach Durchführung des längeren Dünnstabs (1) durch das Becken (5) und einer Trocknung des längeren Dünnstabs (1) dieser in einen Folienschlauch (100) eingeführt und verpackt wird.

9. Verfahren nach einem der Ansprüche 1 bis 8, wobei das Verschweißen der wenigstens zwei abgetrennten Dünnstäbe (11, 12) zu einem längeren Dünnstab (1) in einer inerten Atmosphäre mittels Induktionsschweißen erfolgt.

10. Verfahren nach Anspruch 9, wobei eine über einem mit Quarz gekapselten Rohr (4) aus Kohlenstoff angeordnete Induktionsspule (3) jeweils ein Ende der Dünnstäbe (11) und (12) über die Schmelztemperatur von Silicium erhitzt, wodurch sich ein Tropfen aus flüssigem Silicium bildet, nach einigen Minuten die Induktionsspule (3) ausgeschaltet wird, wobei die Stäbe (11) und (12) zum längeren Dünnstab (1) zusammenwachsen.

## Claims

1. Method for producing thin silicon rods (1), comprising the steps:
a) providing a rod of polycrystalline silicon, from which at least two thin rods (11, 12) with a reduced cross section in comparison with the polycrystalline silicon rod are separated;
b) cleaning the at least two separated thin rods (11, 12) by treatment with a material-eroding liquid medium;
c) welding at least two of the cleaned thin rods (11, 12) to form a longer thin rod (1);
d) packaging the longer thin rod (1) in a tubular film (100).

2. Method according to Claim 1, wherein, after the welding of at least two of the thin rods (11, 12) to form a longer thin rod (1) and before the latter is packaged, a second cleaning in which the longer thin rod (1) is treated with a material-eroding liquid medium is carried out.

3. Method according to Claim 1 or 2, wherein the liquid medium for treating the thin rods (11, 12) according to step b) and in the second cleaning of the longer thin rod (1) contains HF and HNO₃.

4. Method according to Claim 2 or 3, wherein hydrophilization of the thin rods (11, 12) is carried out after cleaning according to step b) and hydrophilization of the longer thin rod (1) is carried out after the second cleaning by means of ozone.

5. Method according to one of Claims 2 to 4, wherein, in the treatment of the longer thin rod (1) with a material-eroding liquid medium, the material erosion is less than 10 µm.

6. Method according to one of Claims 1 to 5, wherein, in the cleaning of the thin rods (11, 12) by treatment with a material-eroding liquid medium according to step b), the material erosion is respectively at least 10 µm.

7. Method according to one of Claims 2 to 6, wherein the second cleaning of the longer thin rod (1) is carried out in a tank (5), containing material-eroding liquid medium, which on both end faces has an opening (51) and (52), respectively, through which the longer thin rod (1) is passed gradually in order to clean it, material-eroding liquid medium which flows out along the longer thin rod (1) through the openings (51) and (52) being collected in a trough (7) arranged below the tank (5) and pumped back into the tank (5).

8. Method according to Claim 7, wherein, after passing the longer thin rod (1) through the tank (5) and drying the longer thin rod (1), it is introduced into a film tube (100) and packaged.

9. Method according to one of Claims 1 to 8, wherein the welding of the at least two separated thin rods (11, 12) to form a longer thin rod (1) is carried out by means of induction welding in an inert atmosphere.

10. Method according to Claim 9, wherein an induction coil (3) arranged over a quartz-encapsulated carbon tube (4) respectively heats one end of the thin rods (11) and (12) to above the melting temperature of silicon, so that a drop of liquid silicon is formed, and after a few minutes the induction coil (3) is switched off and the rods (11) and (12) fuse to form the longer thin rod (1).

## Revendications

1. Procédé pour la fabrication de fines barres de silicium (1), comprenant les étapes
a) disposition d'une barre de silicium polycristallin, duquel on sépare au moins deux barres fines (11, 12) à section transversale réduite par rapport à la barre de silicium polycristallin ;
b) nettoyage des au moins deux barres fines séparées (11, 12), par traitement par un milieu liquide enlevant de la matière ;
c) soudage d'au moins deux des barres fines (11, 12) nettoyées, en une barre fine plus longue (1) ;
d) emballage de la barre fine plus longue (1) dans un film en forme de gaine (100).

2. Procédé selon la revendication 1, dans lequel, après le soudage d'au moins deux des barres fines (11, 12) en une barre fine plus longue (1) et avant l'emballage de celle-ci, on effectue un deuxième nettoyage, dans lequel on traite la barre fine plus longue (1) par un milieu liquide enlevant de la matière.

3. Procédé selon la revendication 1 ou 2, dans lequel le milieu liquide destiné au traitement des barres fines (11, 12) selon l'étape b) ainsi que pour le deuxième nettoyage de la barre fine plus longue (1) comporte du HF et du HNO₃.

4. Procédé selon la revendication 2 ou 3, dans lequel une hydrophilisation des barres fines (11, 12) après le nettoyage selon l'étape b) ainsi que de la barre fine plus longue (1) après le deuxième nettoyage a lieu au moyen d'ozone.

5. Procédé selon l'une quelconque des revendications 2 à 4, dans lequel l'enlèvement de matière lors du traitement de la barre fine plus longue (1) par un milieu liquide enlevant de la matière est inférieur à 10 µm.

6. Procédé selon l'une quelconque des revendications 1 à 5, dans lequel l'enlèvement de matière lors du nettoyage des barres fines (11, 12) par traitement par un milieu liquide enlevant de la matière selon l'étape b) est chaque fois d'au moins 10 µm.

7. Procédé selon l'une quelconque des revendications 2 à 6, dans lequel le deuxième nettoyage de la barre fine plus longue (1) s'effectue dans une cuve (5) contenant un milieu liquide enlevant de la matière, qui comporte sur chacune des deux faces frontales un orifice (51) ou respectivement (52), par lequel on fait passer progressivement la barre fine plus longue (1) afin de la nettoyer, le milieu liquide enlevant de la matière qui s'échappe par les orifices (51) et (52) au niveau de la barre fine plus longue (1) étant recueilli dans un bac (7) disposé au-dessous de la cuve (5) et renvoyé par pompage dans la cuve (5).

8. Procédé selon la revendication 7, **caractérisé en ce qu'**après le passage de la barre fine plus longue (1) dans la cuve (5) et un séchage de la barre fine plus longue (1), celle-ci est introduite et emballée dans un film en forme de gaine (100).

9. Procédé selon l'une quelconque des revendications 1 à 8, dans lequel le soudage des au moins deux barres fines (11, 12) séparées en une barre fine plus longue (1) s'effectue par soudage par induction dans une atmosphère inerte.

10. Procédé selon la revendication 9, dans lequel une bobine d'induction (3) placée au-dessus d'un tube en carbone (4) entouré de quartz chauffe une extrémité de chacune des barres fines (11) et (12) au-dessus de la température de fusion du silicium, de sorte qu'il se forme une goutte de silicium liquide, quelques minutes après on met hors circuit la bobine d'induction (3), les barres (11) et (12) s'assemblant en la barre fine plus longue (1).
